# EUROPEAN PATENT APPLICATION

(11) **EP 2 003 690 A2**
(43) Date of publication of application: **17.12.2008**
(21) Application number: 08156713.3
(22) Date of filing: 22.05.2008
(51) Int. Cl.: H01L 23/373

(54) **Metal screen and adhesive composite thermal interface**

(30) Priority: 15.06.2007 US 818827
(71) Applicant: Delphi Technologies, Inc., Troy, Michigan 48007 (US)
(72) Inventor: Brandenburg, Scott D., Kokomo, IN 46902 (US); Taylor, Ralph S., Noblesville, IN 46060 (US); Sozansky, Wayne A., Greentown, IN 46936 (US)
(74) Representative: Denton, Michael John

(57) **Abstract**

An improved thermal interface material for conducting heat away from an integrated circuit device into a heat sink is a composite material including a metal screen defining openings and a hardened structural bonding agent incorporated into the openings of the metal screen. The improved composite thermal interface material achieves outstanding bonding properties superior to conventional thermal interface materials, while also exhibiting exceptional thermal conductivity.

## Description

### Technical Field

This invention relates to processes and structures for improving heat dissipation from electronic devices, and more particularly to thermal interfaces between integrated circuit devices and heat sinks.

### Background of the Invention

Conventional techniques for conducting heat from an integrated circuit device to a heat sink, such as an aluminum body, have generally included the use of solder joints or thermal grease to achieve the desired thermally conductive interface between the integrated circuit device and the heat sink. However, while solder joints provide good thermal conductivity, the relatively large difference between the coefficient of thermal expansion of the integrated circuit device substrate (typically silicon) and the heat sink induces fairly large stresses on the solder joints during thermal cycling of the device, leading to cracking and fracture, resulting in an undesirably short service life. While conventional thermal greases eliminate or reduce the problems associated with the mismatch between the coefficient of thermal expansion of the integrated circuit device substrate and the heat sink, thermal greases offer very limited thermal performance (i.e., they do not facilitate thermal conductivity comparable to solder joints).

### Summary of the Invention

The invention involves the use of a thermal interface composite material disposed between an integrated circuit device and a heat sink, wherein the thermal interface composite material comprises a metal screen defining openings and a bonding agent incorporated into the openings of the metal screen. The thermal interface composite material provides a superior combination of bonding strength and thermal conductivity that is not achieved with conventional thermal interface materials.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a top plan view of a compressed copper mesh useful as the metal screen in the thermal interface composite material of the invention.
FIG. 2 is a cross-sectional view of an electronic component having a thermal interface composite material disposed between an integrated circuit device and a heat sink to form an electronic component in accordance with the invention.
FIGs. 3A-3F illustrate an assembly process in accordance with the invention.
FIGs. 4A-4E illustrate an alternative assembly process also in accordance with the invention.

### Description of the Preferred Embodiments

In accordance with the various aspects and embodiments of this invention, a thermal interface composite material comprised of a metal screen defining openings and a bonding agent incorporated into the openings is disposed between an integrated circuit device and a heat sink to provide an exceptional combination of bonding strength and thermal conductivity.

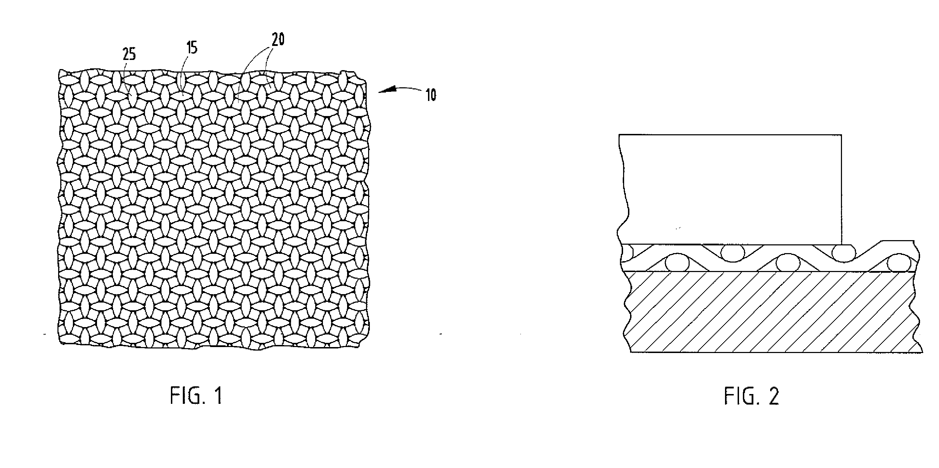

FIG. 1 shows a metal screen 10 comprised of copper filaments or threads 15 that are woven into a fabric mesh defining openings 20. The illustrated metal screen 10 has flattened upper surfaces 25 and similar flattened surfaces on the opposite side (not shown). This flattening of the opposite surfaces of the metal screen that contact the heat sink and the circuit board substrate can be achieved by compressing a conventional wire screen between two planar surfaces or platens. A desirable flattening can be achieved with a standard 100 mesh screen or sieve comprised of woven copper filaments or threads having a diameter of 0.0045 inches using a force of from about 200 psi to about 800 psi. While flattening of the upper and lower surfaces of the screen is not essential, it increases the area of contact between the metal screen and the integrated circuit device and between the metal screen and a heat sink when it is incorporated into a composite thermal interface disposed between the integrated circuit device and the heat sink.

While the metal screen is most desirably provided in the form of a wire mesh screen having woven metal filaments or threads, other metal screens may be used. Examples of other suitable metal screens for use in the composite interface materials of this invention include metal screens prepared by perforating a metal foil, such as by etching, punching, or otherwise providing a plurality of openings.

Copper and copper alloys are currently a preferred material for use in making or providing the metal screens used in the composite thermal interfaces of this invention because of their high thermal conductivity, low cost and malleability. However, other metals may be employed, such as nickel, silver, gold, aluminum, iron and alloys thereof. Metal screens comprised of woven metal filaments or threads which may be used include those in which the filaments have a diameter of from about 1 mil (26 micrometers) to about 50 mils (1300 micrometers) and define openings of from about 1 mil (26 micrometers) to about 50 mils (1300 micrometers).

The structural bonding agent that is incorporated into the openings defined in the metal screen may be either a thermosetting resin material or a thermoplastic material. Suitable thermosetting materials that may be used for preparing the thermal interface composite materials of this invention include epoxy reins, phenolic resins, melamine-formaldehyde resins, etc. with epoxy resins being preferred. The thermosetting resin being used to prepare the composite thermal interfaces of the invention may be so-called "B-stage" resins, which refers to a stage of some thermosetting resins characterized by softening up of the resin when heated and swelling when in the presence of certain liquids. So-called "snap-cure" epoxy resins such as those disclosed in U.S. Patent No. 5,770,706 may be utilized. Examples of thermoplastic materials that may be employed in the composite thermal interfaces of this invention include polyvinyl acetate, acrylic solvent cement (e.g., polymethylmethacrylate dissolved in methyl chloride), acrylic, toughened acrylic resins, cyanoacrylates, silicone resins, polyamines and anaerobic acrylic acid diesters.

In general, the electronic components having a composite thermal interface material disposed between an integrated circuit device and a heat sink is prepared by disposing between the integrated circuit device and heat sink, a thermal interface composite material comprising a metal screen defining openings and a fluid structural bonding agent incorporated in the openings, and subsequently hardening or curing the fluid structural bonding agent. In the case of thermosetting compositions, the expression "hardening" or "curing" refers to a chemical cross-linking reaction that causes the liquid resin composition to become irreversibly converted into a solid material, which typically cannot be reconstituted in any way except by decomposition. In the case of thermoplastic materials, hardening or curing refers to either evaporation of a solvent or solidification of a molten thermoplastic material.

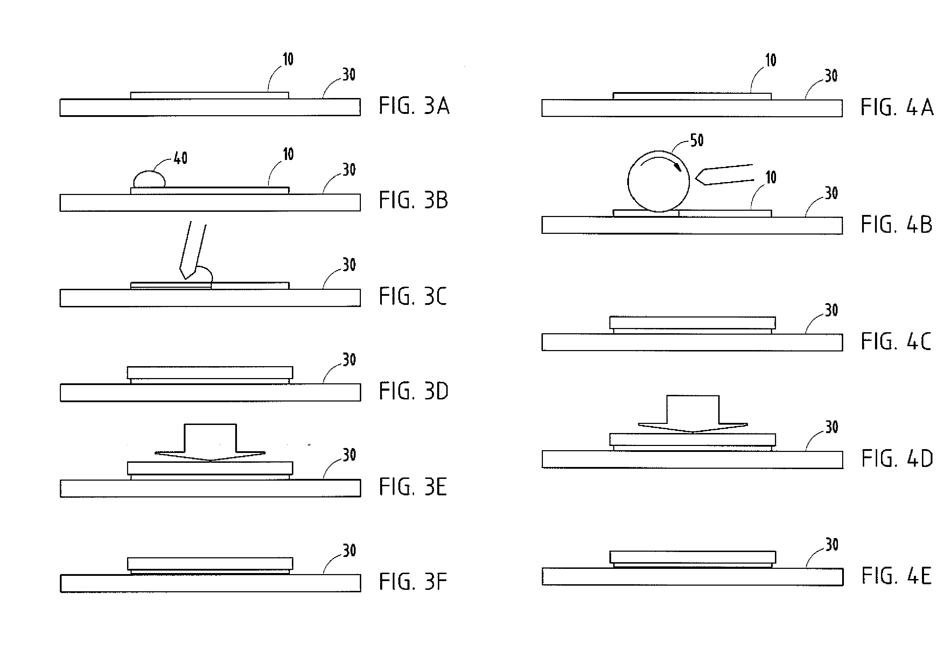

A preferred technique for preparing an electronic component in accordance with the invention is illustrated in FIGs. 3A through 3F.

In FIG. 3A, a metal screen 10 is placed on heat sink 30. In the illustrated embodiment, heat sink 30 has a plate-like structure or shape. However, it should be understood that the heat sink may have other shapes, and may include fins or other structures to enhance transfer of heat from heat sink 30 to the surrounding air by convection.

Thereafter, as shown in FIG. 3B, a structural adhesive agent composition 40 is applied over metal screen 10 and spread as shown in FIG. 3C so that composition 40 enters into openings in metal screen 10, and preferably fills the openings. As shown in FIG. 3D, the integrated circuit device is placed over screen 10 impregnated with adhesive composition 40. Pressure in then applied as suggested in FIG. 3E, such as with a clamp, and the adhesive composition 40 impregnated into the metal screen 10 is hardened or cured. The pressure in then removed and the completed device is shown in FIG. 3F.

In an alternative assembly process, also in accordance with the invention, a screen 10 is placed on heat sink 30 as shown in FIG. 4A, and an adhesive is applied by means of a roller 50 as shown in FIG. 4B. The steps illustrated in FIGs. 4C through 4E are analogous or the same as those illustrated in FIGs. 3D through 3F and described above.

Examples of bonding agents which may be employed in accordance with the invention are listed in Table 1.

**TABLE 1**

| Other Potential Bonding Agents | | |
|---|---|---|
| Material | CTE | Cure Cycle |
| Cookson 3090 | 38 | 150°C 20 minutes |
| ShinEtsu 9030 | 200 | 150°C 20 minutes |
| Loctite 3509 | 72 | During solder reflow |
| No-Flow Material | 82 | During solder reflow |
| Henkel OM 360 | 280 | 200°C melt |
| Loctite 214-HP | 80 | 150°C 20 minutes |
| B-stage epoxy | 74 | Varies |

The relevant material properties characterizing the strength of the adhesive bond in terms of shear force and the thermal conductivity for various known thermal interface materials (Examples 1-5) is compared with a composite thermal interface material in accordance with the invention (Example 6) comprising a copper mesh screen impregnated with an epoxy resin (Loctite 214-HP). The results are listed in Table 2 below. The composite thermal interface material of the invention exhibits outstanding thermal conductivity as compared with known thermal interface materials, and a bonding strength comparable to pure epoxy resin, which is an extremely poor thermal conductor.

**TABLE 2**

| Relevant Material Properties | | | |
|---|---|---|---|
| Example | Material | Shear Force (0 Hrs) | Thermal Conductivity |
| 1 | Bergquist Dove | <5 kg | 15 W/m°K |
| 2 | ATTA Film | <5 kg | 83 W/m°K |
| 3 | Sn 75-Pb Solder | 34 kg | 45 W/m°K |
| 4 | Indium Solder | 22 kg | 86 W/m°K |
| 5 | Epoxy | 86 kg | .7 W/m°K |
| 6 | Cu Mesh 214-HP | 72 Kg | 108 W/m°K (measured) |

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. A process for making an electronic device having an integrated circuit device, a heat sink and a highly thermally conductive interface between the integrated circuit device and the heat sink, comprising:
providing an integrated circuit device;
providing a heat sink;
disposing between the integrated circuit device and the heat sink, a thermal interface composite material comprising a metal screen defining openings and a fluid structural bonding agent incorporated in the openings; and
hardening the fluid structural bonding agent to form a solid thermal interface.

2. The process of claim 1, wherein the structural bonding agent is a thermosetting resin material.

3. The process of claim 1, wherein the structural bonding agent is an epoxy resin.

4. The process of claim 1, wherein the structural bonding agent is a B-stage epoxy.

5. The process of claim 1, wherein the structural bonding agent is a snap-cure resin.

6. The process of claim 1, wherein the structural bonding agent is a silicone resin.

7. The process of claim 1, wherein the structural bonding agent is a thermoplastic material.

8. The process of claim 1, wherein the metal screen is comprised of woven metal filaments.

9. The process of claim 1, wherein the metal screen is comprised of a metal foil having a plurality of openings.

10. The process of claim 1, wherein the metal screen is made of copper or a copper alloy.

11. The process of claim 1, wherein the metal screen comprises woven metal filaments having a diameter of from about 1 mil (26 micrometers) to about 50 mils (1300 micrometers) and defines openings of from about 1 mil (26 micrometers) to about 50 mils (1300 micrometers).

12. The process of claim 1, wherein the metal screen is comprised of woven filaments that have a non-circular cross section with flattened surfaces on opposite sides of the screen.

13. A electronic component comprising:
an integrated circuit device;
a heat sink; and
a composite thermal interface material disposed between the integrated circuit device and the heat sink, the composite thermal interface material comprising a metal screen defining openings and a hardened structural bonding agent incorporated into the openings of the metal screen.

14. The electronic component of claim 13, wherein the metal screen is comprised of woven metal filaments.

15. The electronic component of claim 13, wherein the metal screen is comprised of a metal film having a plurality of openings.

16. The electronic component of claim 13, wherein the metal screen is made of copper or a copper alloy.

17. The electronic component of claim 13, wherein the metal screen comprises woven metal filaments having a diameter of from about 1 mil (26 micrometers) to about 50 mils (1300 micrometers) and defines openings of from about 1 mil (26 micrometers) to about 50 mils (1300 micrometers).

18. The electronic component of claim 17, wherein the hardened bonding agent is a thermoset epoxy resin.

19. The electronic component of claim 13, wherein the composite thermal interface has a thermal conductivity greater than 15 W/m°K.

20. The electronic component of claim 13, wherein the composite thermal interface has a thermal conductivity greater than 100 W/m°K.
